# EUROPEAN PATENT APPLICATION

(11) **EP 1 758 183 A1**
(43) Date of publication of application: **28.02.2007**
(21) Application number: 06016138.7
(22) Date of filing: 02.08.2006
(51) Int. Cl.: H01L 51/56

(54) **System and method for reduced material pile-up**

(30) Priority: 26.08.2005 US 212537
(71) Applicant: Osram Opto Semiconductors GmbH, 93049 Regensburg (DE)
(72) Inventor: Frischknecht, Kyle D., Livermore, CA 94550 (US)
(74) Representative: Epping - Hermann - Fischer

(57) **Abstract**

An embodiment of the invention pertains to a two stage process that facilitates the formation of a substantially uniform layer. A material is isotropically deposited on a re-entry shaped surface topography and a substrate resulting in a non-wetting film on the re-entry shaped surface topography and the substrate. Regions of the non-wetting film that are not shadowed by the re-entry shaped surface topography are anisotropically removed resulting in non-wetting shadowed films only in the regions that are shadowed by the re-entry shaped surface topography. The non-wetting shadowed films are non-wetting to a subsequently deposited layer. The non-wetting shadowed films reduce pileup at the edges, and so the subsequently deposited layer has a substantially uniform layer thickness.

## Description

### BACKGROUND OF THE INVENTION

An organic light emitting diode ("OLED") is typically comprised of one or more thin organic layers (e.g., a hole transport layer ("HTL") and an emissive polymer layer) between its anode and cathode. Under an applied forward potential, the anode injects holes into the HTL, while the cathode injects electrons into the emissive polymer layer. The injected holes and electrons each migrate toward the oppositely charged electrode and recombine to form an exciton in the emissive polymer layer. The exciton then transitions from an excited state to a ground state and in the process, emits light.

The one or more organic polymer layers (for example, a hole transport polymer layer comprised of, e.g., polyethylenedioxythiophene doped with polystyrenesulphonate ("PEDOT:PSS"), or an emissive polymer layer comprised of, e.g., poly(para-phenylene vinylene) ("PPV")) can be formed by depositing a liquid solution using either selective deposition techniques (e.g., ink jet printing, flex printing, or screen printing) or nonselective deposition techniques (e.g., spin coating, dip coating, web coating, or spray coating). When liquid solutions wet surfaces, there is a natural tendency for the solution to accumulate at intersection points in the substrate topography due to capillary action. When the solution dries, the regions where accumulation occurred (i.e., regions of pileup) are much thicker than the other regions of the layer resulting in the layer having a nonuniform layer thickness. For example, the nonuniform layer can have a thickness at the regions of accumulation that is greater than ten times the thickness at the center of the layer. A nonuniform layer thickness adversely affects the performance and lifetime of devices such as organic electronic devices (e.g., OLED displays or OLED light sources).

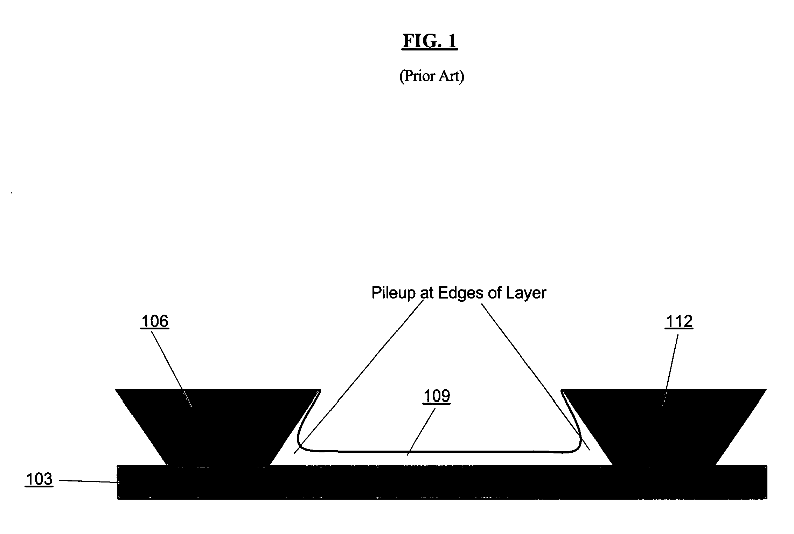

Specifically, when fabricating an organic electronic device, the organic polymer solution is deposited on the substrate and then allowed to dry. Upon drying, the resulting organic polymer layer typically has a nonuniform profile. FIG. 1 shows a partially-completed organic electronic device whose resulting organic polymer layer has a nonuniform layer thickness. In FIG. 1, mushroom structures 106, 112 are on a substrate 103. An organic polymer solution is deposited on the substrate 103 using a deposition technique such as, e.g., spin coating. The organic polymer solution dries to form an organic polymer layer 109 on the substrate 103. As shown in FIG. 1, the resulting organic polymer layer 109 has a nonuniform thickness, and there is substantial pileup of the polymers around the mushroom structures 106, 112. The pileup of the polymers around the mushroom structures is due to capillary action that causes the solution to wick up against the mushroom structures and after this solution dries, there is left a excess pileup of polymers around the mushroom structures 106, 112.

The pileup of the polymers around the mushroom structures 106, 112 decreases device performance and lifetime. For example, the pileup results in poorly defined pixel edges (i.e., poor pixel demarcation) thus potentially decreasing the active area of the pixel since the brightness is greatly diminished along the pixel edges of some sides of the pixel. In addition, the pileup likely increases the row gap size between pixels if mushroom structures separate different rows of the display or alternatively, increase column gap size if mushroom structures separate different columns of the display. Also, the pileup of polymers can cause the electric field across the layer to be non-uniform (the electric field is inversely proportional to the thickness of the film). The non-uniform electric field results in non-uniform electric current passing through the layer with less current in the thicker regions near the edges of the layer and more current in the thinner regions near the center of the layer. The non-uniform current across the layer results in non-uniform light emission across the layer. Also, the higher current at the thinner regions makes these regions more vulnerable to electric shorts which can render the OLED unusable. The higher current density is expected to increase the rate of degradation of the device and lead to a lower overall lifetime of the device.

For the foregoing reasons, the electronic device should have active layer(s) (e.g., organic polymer layer(s)) that have a substantially uniform thickness in order to improve, for example, device performance and lifetime.

### SUMMARY

An embodiment of a method is described to fabricate an electronic device that includes a re-entry shaped surface topography on a substrate. The method includes isotropically depositing a material to form a non-wetting film on the re-entry shaped surface topography and the substrate. The method also includes anisotropically removing regions of the non-wetting film that are not shadowed by the re-entry shaped surface topography to produce a non-wetting shadowed film. The non-wetting shadowed film is non-wetting to another material that is subsequently deposited.

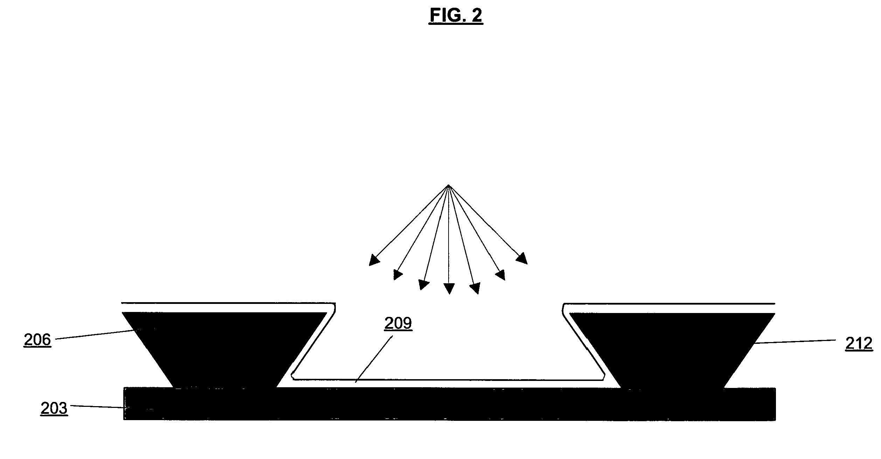

An embodiment of an electronic device is also described. This device includes a substrate, a re-entry shaped surface topography on the substrate; and a non-wetting shadowed film on regions of the re-entry shaped surface topography and the substrate that are shadowed by the re-entry shaped surface topography. The non-wetting shadowed film is non-wetting to a subsequently deposited layer.
In a further embodiment the re-entry shaped surface topography comprises structures with an overhanging edge shape, shadowing the parts of the substrate under the overhanging edge (see for example Fig. 2).

### BRIEF DESCRIPTION OF THE DRAWINGS

FIG. 1 shows a partially-completed organic electronic device whose resulting organic polymer layer has a nonuniform layer thickness.
FIG. 2 shows the first stage of the process for forming the non-wetting film underneath the re-entry shaped surface topography according to an embodiment of the present invention.
FIG. 3 shows the second stage of the process for forming the non-wetting film underneath the re-entry shaped surface topography according to the embodiment of the present invention.
FIG. 4 shows an embodiment of the profile of the subsequently deposited layer when employing the non-wetting shadowed film.
FIG. 5 shows a flowchart of an embodiment of a process to fabricate an electronic device according to the present invention.

### DETAILED DESCRIPTION

An embodiment of this invention pertains to an electronic device (e.g., an organic electronic device) that includes one or more layers (e.g., organic polymer layers) that have a substantially uniform layer thickness. A layer is considered to have a substantially uniform layer thickness if the thickness across the width of the layer is within ±20% of the thickness at its center, preferably, within ±10% of the thickness at its center. The remainder of this specification refers specifically to organic electronic devices and organic polymer layers in order to provide concrete examples, however, the invention is applicable to any electronic device and any layer. In this embodiment of the invention, the organic polymer layer(s) having the substantially uniform layer thickness result from employing non-wetting film that is shadowed by a re-entry shaped surface topography. The non-wetting film is non-wetting to a subsequently deposited material. In this embodiment, the non-wetting film is formed in those regions that are shadowed by the re-entry shaped surface topography by using a two stage processes. The first stage isotropically (i.e., non-directionally) deposits a material to form a non-wetting film on the substrate and the re-entry shaped surface topography. The second stage anisotropically (i.e., directionally) removes regions of the non-wetting film that is not shadowed by the re-entry shaped surface topography. The remaining non-wetting film is non-wetting to a subsequently deposited material and this non-wetting behavior reduces pileup of the subsequently deposited material around the re-entry shaped surface topography (e.g., around the edges of the subsequently deposited layer). This embodiment of the invention allows the regions shadowed by the re-entry shaped surface topography to have a different wetting behavior than the other regions of the substrate. Specifically, the regions shadowed and underneath the re-entry shaped surface topography have non-wetting behavior to reduce material pileup at the edges of the subsequently deposited layer, while the other regions can have good wetting behavior to allow for sufficient spreading of the subsequently deposited solution during the deposition process.

FIG. 2 shows the first stage of the process for forming the non-wetting film underneath the re-entry shaped surface topography according to an embodiment of the present invention. In FIG. 2, re-entry shaped surface topographies ("surface topographies") 206, 212 are on a substrate 203. A non-wetting conformal material is isotropically (i.e., non-directionally) deposited over the surface topographies 206, 212 and also the substrate 203. The non-wetting conformal material dries to form a non-wetting film 209 that is on the substrate 203 and the surface topographies 206, 212. The non-wetting film 209 is non-wetting to another material that is subsequently deposited.

As used within the specification and the claims, the term "on" includes when layers are in physical contact and when layers are separated by one or more intervening layers. In contrast, the term "directly on" means that the layers are in physical contact with each other. Some of the layers mentioned earlier are described in greater detail below:

### Substrate 203:

The substrate 203 can be comprised of a single layer or multiple layers. The single layer substrate can be comprised of glass, quartz, silicon, plastic, or stainless steel. Similarly, the bottom-most layer of the multi-layer substrate can be comprised of glass, quartz, silicon, plastic, or stainless steel. The multi-layer substrate includes one of more additional layers on the bottom-most layer; the multi-layer substrate can have, e.g., the following structures: (i) a first electrode layer (e.g., an anode layer comprised of indium tin oxide ("ITO") that is patterned or unpatterned) on the bottom-most layer; or (ii) the first electrode layer on the bottom-most layer, and also metal lead-in lines and metal pads on the bottom-most layer. In addition, one or more buffer layers or barrier layers can be present on either side of the single layer substrate or the bottom-most layer of the multi-layer substrate.

### Re-entry Shaped Surface Topographies 206, 212:

The re-entry shaped surface topographies 206, 212 can be, for example, an in-situ shadow mask ("ISM") which is also known as a mushroom structure. The surface topographies 206, 212 can be made of, for example, a photo-resist material such as, e.g., polyimides or polysiloxanes. The photo-resist material can be either positive photo-resist material or negative photo-resist material. The surface topographies 206, 212 are insulating structures that can be used to, e.g., electrically isolate one electrode strip from another, and also to electrically isolate the cathode from the anode. The surface topographies 206, 212 can be patterned by, e.g., applying lithography techniques to the photo-resist material, or by using screen printing or flexo-printing to deposit the bank material in the desired pattern.

### Non-wetting film 209:

The non-wetting film 209 is non-wetting to a subsequently deposited material (e.g., the subsequently deposited layer can be, for example, the HTL or the emissive layer). More specifically, for example, the non-wetting film 209 is comprised of a material that has a lower surface energy than the subsequently deposited material. The non-wetting film 209 can be comprised of either an organic material or an inorganic material. For example, if the subsequently deposited material is a polyethylenedioxythiophene-polystyrenesulfonate ("PEDOT:PSS") solution that has a surface tension of approximately 30 dynes/cm, then the non-wetting film 209 can be comprised of, e.g., the following materials: parylene (e.g., parylene N), polyhexafluoropropylene, polytetrafluoroethylene ("PTFE"), chlorotrifluoroethylene, polydimethyl siloxane, natural rubber, and polyvinylidene fluoride ("PVDF"). In another example, if the subsequently deposited material is an emissive material deposited from solution that has a surface tension of approximately 24 dynes/cm, then the non-wetting film 209 can be comprised of, e.g., the following materials: PTFE, PVDF, tetrafluoroethylene-perfluoroalkylvinylether copolymers ("PFA"), polyenes (e.g., polyethylene and polypropylene), and nylon. Alternatively, the non-wetting film 209 can be comprised of inorganic materials such as, e.g., silicon nitride ("SiNₓ"), silicon oxide ("SiOₓ"), aluminum oxide ("Al₂O₃"), or aluminum nitride ("AlN").

The non-wetting material is deposited using isotropic deposition techniques such as, e.g., spin-coating, sputtering, thermal evaporation, chemical vapor deposition ("CVD"), plasma enhanced chemical vapor deposition ("PECVD"), vapor prime, or an improved vapor deposition process of self-assembling monolayers that incorporates in-situ surface plasma treatment and the precise delivery of precursor vapors and this is commercially available under the trademark "MOLECULAR VAPOR DEPOSITION".

### Non-Wetting Shadowed Film 215:

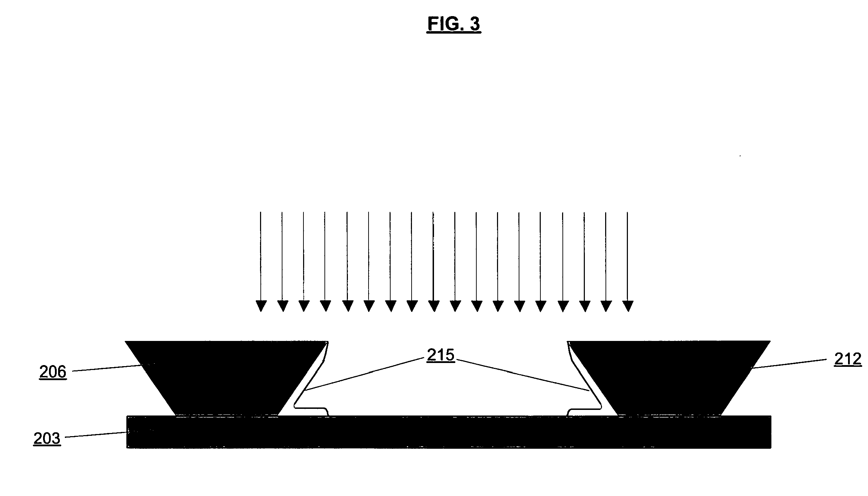

FIG. 3 shows the second stage of the process for forming the non-wetting film underneath the re-entry shaped surface topography according to the embodiment of the present invention. In FIG. 3, an anisotropic (i.e., highly directional) removing process is used to remove regions of the non-wetting film 209 that are not shadowed by the surface topography 206 in order to produce the non-wetting shadowed film 215. Anisotropic removing processes include, e.g., etching and laser ablation. More specifically, the etching process can be, e.g., reactive ion etching ("RIE") or etching at low pressure to minimize scattering.

The non-wetting behavior of the non-wetting shadowed film 215 reduces pileup of the subsequently deposited material around the surface topography (e.g., reduces pileup at the edges of the subsequently deposited layer). Since the regions covered by the non-wetting shadowed film 215 are much smaller than the remaining regions (e.g., the remaining regions are the top sides of the surface topographies 206, 212 and also the non-shadowed regions of the substrate 203), most of the pertinent regions have good wetting and spreading behavior and thus there will be sufficient spreading of the subsequently deposited solution.

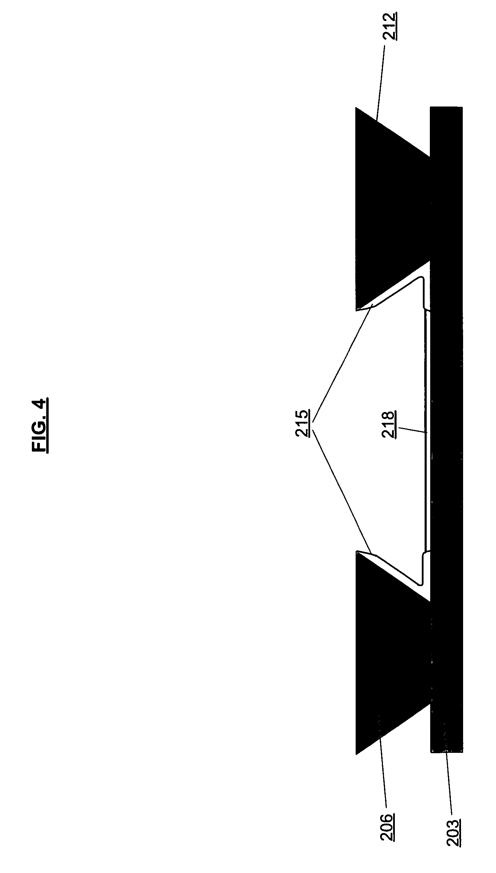

FIG. 4 shows an embodiment of the profile of the subsequently deposited layer 218 when employing the non-wetting shadowed film 215. Upon depositing the solution, the solution readily spreads on the tops of the surface topographies 206, 212 and/or the non-shadowed regions of the substrate 203 because of the good wetting behavior of these regions. When the solution reaches the non-wetting shadowed film 215, the non-wetting behavior of these regions hinder the spreading of the deposited solution thus preventing pileup at the edges of the solution and around the surface topographies 206, 212. Thus, the subsequently deposited layer 218 has a substantially uniform layer thickness. There can be almost no pileup at the edges of the layer 218 (as shown) or there can be some pileup, nevertheless, the thickness at the edges is within ±20% of the thickness at the center, preferably, within ±10% of the thickness at the center.

In another embodiment, the non-wetting shadowed film 215 can be produced using photoresist material. In this embodiment, in order to produce the non-wetting shadowed film 215, the photoresist material is isotropically deposited on the surface topographies 206, 212 and also the substrate 203 in order to form a photoresist layer on these regions. Then, the photoresist layer is anisotropically exposed to ultraviolet ("UV") radiation. The regions of the substrate 203 that is shadowed by the surface topographies 206, 212 will not be exposed to the UV radiation while the remaining regions will be exposed to the UV radiation. Then, the photoresist layer is isotropically exposed to a stripping material so that either the UV-exposed regions of the photoresist layer or the unexposed regions of the photoresist layer are removed.

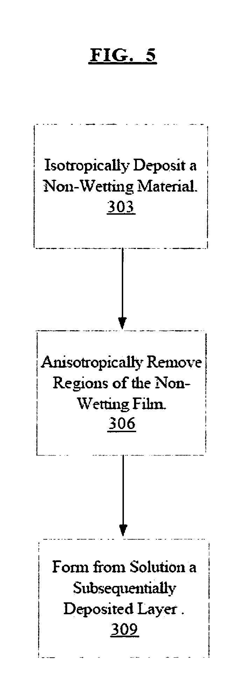

FIG. 5 shows a flowchart of an embodiment of a process to fabricate an electronic device according to the present invention. In block 303, a non-wetting material is isotropically deposited in order to form the non-wetting film 209 on the re-entry shaped surface topographies 206, 212 and also the substrate 203. The non-wetting material is non-wetting to a subsequently deposited material; the subsequently deposited material can form, e.g., the active layer of the electronic device. The non-wetting material can be isotropically deposited using any of the following deposition techniques: spin-coating, sputtering, thermal evaporation, chemical vapor deposition ("CVD"), plasma enhanced chemical vapor deposition ("PECVD"), vapor prime, or "MOLECULAR VAPOR DEPOSITION". The non-wetting film can be comprised of either an organic material or an inorganic material. Examples of organic materials that can be used include, e.g., parylene; examples of inorganic materials that can be used include, e.g., silicon nitride ("SiNₓ"), silicon oxide ("SiOₓ"), aluminum oxide ("Al₂O₃"), or aluminum nitride ("AlN").

In block 306, regions of the non-wetting film 209 are anisotropically removed to produce non-wetting shadowed film 215 in areas that are shadowed by the surface topographies 206, 212 (e.g., the regions that are removed are the areas not shadowed by the re-entry shaped surface topographies 206, 212). The non-wetting film 209 can be anisotropically removed using, e.g., the following techniques: etching or laser ablation. Etching includes, e.g., reactive ion etching, or etching at low pressure to minimize scattering.

In block 309, the subsequently deposited layer 218 (e.g., an active layer) of the electronic device is formed from solution. The non-wetting shadowed film 215 reduces pileup at the edges of the subsequently deposited layer 218 so that the resulting layer 218 has substantially uniform thickness. The subsequently deposited layer 218 can be, e.g., an active layer of the electronic device such as, e.g., a hole transport layer or an emissive layer. The hole transport layer can be comprised of, e.g., polyethylenedioxythiophene-polystyrenesulfonate ("PEDOT:PSS") or conducting polyaniline. The emissive layer can be comprised of, e.g., polyfluorenes or polyspiro polymers. Optionally, the emissive layer can contain phosphors. The subsequently deposited layer 218 can be deposited, e.g., using any of the following techniques: spin coating, dip coating, web coating, spray coating, ink jet printing, flex printing, or screen printing.

In addition, the electronic device can include additional layers. For example, the electronic device can include an interlayer that is between, e.g., the hole transport layer and the emissive layer. Also, the electronic device can include a phosphor layer that is on the emissive layer. In addition, the electronic device can include a second electrode (e.g., a cathode). The cathode is typically a multilayer structure that includes, for example, a thin charge injection layer that has a lower work function and a thick conductive layer. The charge injection layer can be comprised of, for example, calcium or barium or mixtures thereof. The conductive layer can be comprised of, for example, aluminum, silver, magnesium, gold, copper, or mixtures thereof.

The electronic device described herein can be, e.g., an OLED display or an OLED light source used for general purpose lighting. The OLED display can be used in applications such as, e.g., computer displays, information displays in vehicles, television monitors, telephones, printers, and illuminated signs.

As any person of ordinary skill in the art of electronic device fabrication will recognize from the description, figures, and examples that modifications and changes can be made to the embodiments of the invention without departing from the scope of the invention defined by the following claims.

## Claims

1. A method to fabricate an electronic device, said device includes a re-entry shaped surface topography on a substrate, said method comprising:
isotropically depositing a material to form a non-wetting film on said re-entry shaped surface topography and said substrate; and
anisotropically removing a region of said non-wetting film that is not shadowed by said re-entry shaped surface topography to produce a non-wetting shadowed film,
wherein said non-wetting shadowed film is non-wetting to another material that is subsequently deposited.

2. The method of claim 1 wherein said re-entry shaped surface topography is an in-situ shadow mask ("ISM").

3. The method according to any of the preceding claims wherein isotropically depositing includes using any of the following techniques: spin-coating, sputtering, thermal evaporation, chemical vapor deposition, plasma enhanced chemical vapor deposition, vapor prime, or an improved vapor deposition process of self-assembling monolayers that incorporates in-situ surface plasma treatment and the precise delivery of precursor vapors which is commercially available under the trademark "MOLECULAR VAPOR DEPOSITION".

4. The method according to any of the preceding claims wherein said non-wetting material includes an organic material or an inorganic material, and wherein said non-wetting material has a lower surface energy than said subsequently deposited material.

5. The method of claim 4 wherein
said organic material is parylene, polyhexafluoropropylene, polytetrafluoroethylene ("PTFE"), chlorotrifluoroethylene, polydimethyl siloxane, natural rubber, polyvinylidene fluoride ("PVDF"), tetrafluoroethylene-perfluoroalkylvinylether copolymers ("PFA"), polyenes, or nylon; and
said inorganic material is silicon nitride ("SiNₓ"), silicon oxide ("SiOₓ"), aluminum oxide ("Al₂O₃"), or aluminum nitride ("AlN").

6. The method according to any of the preceding claims wherein anisotropically removing includes etching or laser ablation.

7. The method of claim 6 wherein said etching includes: (i) reactive ion etching ("RIE"), or (ii) etching at low pressure.

8. The method according to any of the preceding claims further comprising forming a subsequently deposited layer directly on at least one of: (i) said substrate and (ii) said non-wetting shadowed film, wherein said subsequently deposited layer has a substantially uniform thickness.

9. The method of claim 8 wherein said substantially uniform thickness is defined as having thickness across the width of said layer that is within ±20% of the thickness at its center.

10. The method of claims 8 or 9 wherein said subsequently deposited layer is a hole transport layer and further comprising:
optionally forming an interlayer on said hole transport layer;
forming an emissive layer on said interlayer if present, otherwise, on said hole transport layer; and
optionally forming a phosphor layer on said emissive layer.

11. The method of claim 10 wherein said emissive layer includes phosphors.

12. The method according to any of the preceding claims wherein
isotropically depositing said non-wetting material includes isotropically coating said re-entry shaped surface topography and said substrate with a photoresist material; and
anisotropically removing said portion of said non-wetting film includes
(i) anisotropically exposing said photoresist layer to UV radiation; and
(ii) isotropically exposing said photoresist layer to a stripping material so that either said UV-exposed portion of said photoresist layer or said unexposed portion of said photoresist layer is removed.

13. An electronic device, comprising:
a substrate;
a re-entry shaped surface topography on said substrate; and
a non-wetting shadowed film on a region of said re-entry shaped surface topography and said substrate that is shadowed by said re-entry shaped surface topography,
wherein said non-wetting shadowed film is non-wetting to a subsequently deposited layer.

14. The device of claim 13 wherein said subsequently deposited layer is on at least one of: (i) said substrate and (ii) said non-wetting shadowed film, wherein said subsequently deposited layer has a substantially uniform thickness.

15. The device of claim 14 wherein said substantially uniform thickness is defined as having thickness across the width of said substantially uniform layer that is within ±20% of the thickness at its center.

16. The device of any of the claims 13 to 15 wherein said re-entry shaped surface topography is an in-situ shadow mask ("ISM").

17. The device of claims 13 to 16 wherein said non-wetting material includes an organic material or an inorganic material, and wherein said non-wetting material has a lower surface energy than said subsequently deposited material.

18. The device of claim 17 wherein
said organic material is parylene, polyhexafluoropropylene, PTFE, chlorotrifluoroethylene, polydimethyl siloxane, natural rubber, PVDF, PFA, polyenes, or nylon; and
said inorganic material is SiNₓ, SiOₓ, Al₂O₃, or AIN.

19. The device of claims 13 to 18 wherein said subsequently deposited layer is a hole transport layer and further comprising:
optionally, an interlayer on said hole transport layer;
an emissive layer on said interlayer if present, otherwise, on said hole transport layer; and
optionally, a phosphor layer on said emissive layer.

20. The device of claims 13 to 19 wherein said non-wetting shadowed film is a photoresist.
